# EUROPEAN PATENT APPLICATION

(11) **EP 0 831 532 A2**
(43) Date of publication of application: **25.03.1998**
(21) Application number: 97307284.6
(22) Date of filing: 19.09.1997
(51) Int. Cl.: H01L 27/108, H01L 21/8242

(54) **Semiconductor memories**

(30) Priority: 19.09.1996 US 56925 P
(71) Applicant: TEXAS INSTRUMENTS INCORPORATED, Dallas Texas 75265 (US)
(72) Inventor: Miyai, Yoichi, Toride-City, Ibaraki 302 (JP); Yoshida, Hiroyuki, Ryugasaki-City, 301 (JP)
(74) Representative: Legg, Cyrus James Grahame

(57) **Abstract**

A DRAM cross point memory cell (1800) forms the pass transistor vertically in an upstanding portion (502) of semiconductor material or pillar electrically isolated from other cells by a trench isolation material (602). A chamber (1002) extends down into the upstanding portion (502). Dopant from bit line (704) diffuses into the top parts (1804) of the side walls (1004) to form one of the source/drain electrodes. Part of a word line (1102) extends down into the chamber to form the transistor gate. The gate dielectric is a layer (1010) of SiO2. The other source/drain electrode (1808) is formed of dopant from the storage node material 1502 that diffuses into the bottom wall 1006 of the chamber. The channel region is formed of the side walls (1004) adjacent the gate.

## Description

### TECHNICAL FIELD OF THE INVENTION

This invention relates generally to semiconductor memory devices, and more particularly to forming a cross point memory cell in a dynamic random access memory in a way that also isolates the bit lines from noise in the substrate.

### DESCRIPTION OF THE RELATED ART

The manufacture of integrated circuits generally involves hundreds of individual manufacturing or process steps. This applies to DRAMs particularly. While any generalization of such multitude of operations necessarily omits such defining detail, the manufacturing of ICs can be generally described with four major divisions: prepare blank wafers of semiconductor material, such as silicon; process the blank wafers to form multiple chips containing the desired circuits; package the individual chips and subject the packaged chips to elevated temperature and voltage operating conditions to eliminate early failing chips, i.e. perform burn-in testing. This last step helps insure reliability.

Electrical function and parametric testing occurs during and after processing and after burn-in to ascertain the good electrical chips that are available for further manufacturing steps. The first electrical test of DRAM circuits is known as laser probe. This phrase refers to electrical function testing performed to determine circuits that can be repaired by laser blowing fuses in redundancy circuits. This improves the yield of good chips. The second electrical test of DRAMs is known as multiprobe test. This test applies multiple probes to each chip in determining the function and parameters of the chip prior to packaging. The final electrical test confirms the operability of the chips and is used to sort them by parameters such as speed.

As technology develops, DRAMs need to store more bits of information, use less power per bit of stored information and have the individual memory cells containing the stored bits occupy less area on the semiconductor chip. The smallest theoretical limit of a memory cell is four times the square of the feature size on a chip, or 4F² where F represents minimum feature size. The feature size is the minimum width of the electrical leads or wiring and minimum spacing between wiring on the chip. Each cell comprises a MOS pass transistor and a storage capacitor.

A memory cell that achieves this type of minimum size is known as a cross point cell. This cell gets its name from being located in an array of cells at the point where one wordline and one bit line cross one another. Rather than a folded bit line arrangement, a cross point cell uses an open bit line architecture.

A problem with an open bit line architecture is that detrimental substrate noise couples into the bit lines. The noise results from a substrate potential change capacitively coupling through a p-n junction formed between the bit line and substrate. Folded bit line architectures avoid this problem by having two bit lines, one true and one reference, running parallel with one another; the noise rides on both bit lines and can be eliminated equally from both. The substrate noise problem is substantial in open bit line architectures however and can cause the mis-reading of bits in the cells. This problem of noise remains a serious impediment for using an open bit line architecture.

Another problem has been the number of masks needed to form the cross point cell. The number of masks needed to form the cell influences the number of processing steps needed to make the device. Eliminating even one mask eliminates several processing steps from the process. One particular cross point cell requires 5 masks to complete the cell processing.

### SUMMARY OF THE INVENTION

The present invention overcomes these and other problems by forming the pass transistor vertically in and around a chamber etched into an upstanding portion of semiconductor material or pillar insulated from other cells by a trench isolation arrangement. This places the bit line and word line connections at the top of the upstanding portion and the substrate at the bottom of the upstanding portion. By forming the pass transistor channel region vertically between the bit line and substrate, the capacitive coupling between the bit line and substrate is significantly reduced.

By particular arrangement of the pass transistor and capacitor parts, and the intentional use of deposition process steps with poor step coverage, the number of masks needed to pattern the resulting cell reduces to four. The four masks respectively are used to pattern the active region, the bit line, the word line and the storage node.

In particular, a dynamic random access memory cell comprises a portion of semiconductor material upstanding from a substrate and electrically isolated from other like portions of semiconductor material upstanding from the substrate. The upstanding portion contains a chamber having side walls, a bottom wall and an opening to the top of the chamber between the tops of the side walls. A bit line connects to the top of the side walls. The bit line dopant diffuses into the top of the side walls to form one of a source/drain terminal of a MOS transistor.

A gate electrode, formed of a word line, extends down into the chamber and is electrically separated from the side walls to form a gate of the MOS transistor. A part of the side walls adjacent to the gate forms a channel region of the MOS transistor.

A storage electrode extends down into the chamber and makes electrical connection with the part of the semiconductor material under the bottom wall. The dopant of the storage node diffuses into the semiconductor material of the bottom wall to form the other source/drain electrode. The storage electrode extends above the opening.

### BRIEF DECRIPTION OF THE DRAWINGS

The present invention will now be further described, by way of example, with reference to the accompanying drawings in which:
Figure 1 is a plan view of a dynamic random access memory device depicting a cross point array of memory cells;
Figure 2 is a vertical sectional view of one stacked capacitor dynamic memory cell;
Figure 3 is a plan view of a cross point array of memory cells according to the present invention;
Figure 4 is a vertical sectional view of one memory cell in the array of Figure 3 at a first stage of manufacture;
Figure 5 is a vertical sectional view of the memory cell in Figure 4 at a next stage of manufacture;
Figure 6 is a vertical sectional view of the memory cell in Figure 5 at a next stage of manufacture;
Figure 7 is a vertical sectional view of the memory cell in Figure 6 at a next stage of manufacture;
Figure 8 is a vertical sectional view of the memory cell in Figure 7 at a next stage of manufacture;
Figure 9 is a vertical sectional view of the memory cell in Figure 8 at a next stage of manufacture;
Figure 10 is a vertical sectional view of the memory cell in Figure 9 at a next stage of manufacture;
Figure 11 is a vertical sectional view of the memory cell in Figure 10 at a next stage of manufacture;
Figure 12 is a vertical sectional view of the memory cell in Figure 11 at a next stage of manufacture;
Figure 13 is a vertical sectional view of the memory cell in Figure 12 at a next stage of manufacture;
Figure 14 is a vertical sectional view of the memory cell in Figure 13 at a next stage of manufacture;
Figure 15 is a vertical sectional view of the memory cell in Figure 14 at a next stage of manufacture;
Figure 16 is a vertical sectional view of the memory cell in Figure 15 at a next stage of manufacture;
Figure 17 is a vertical sectional view of the memory cell of Figure 16 at a next stage of manufacture; and
Figure 18 is a vertical sectional view of the memory cell of Figure 17 indicating capacitive couplings.

### DETAILED DESCRIPTION

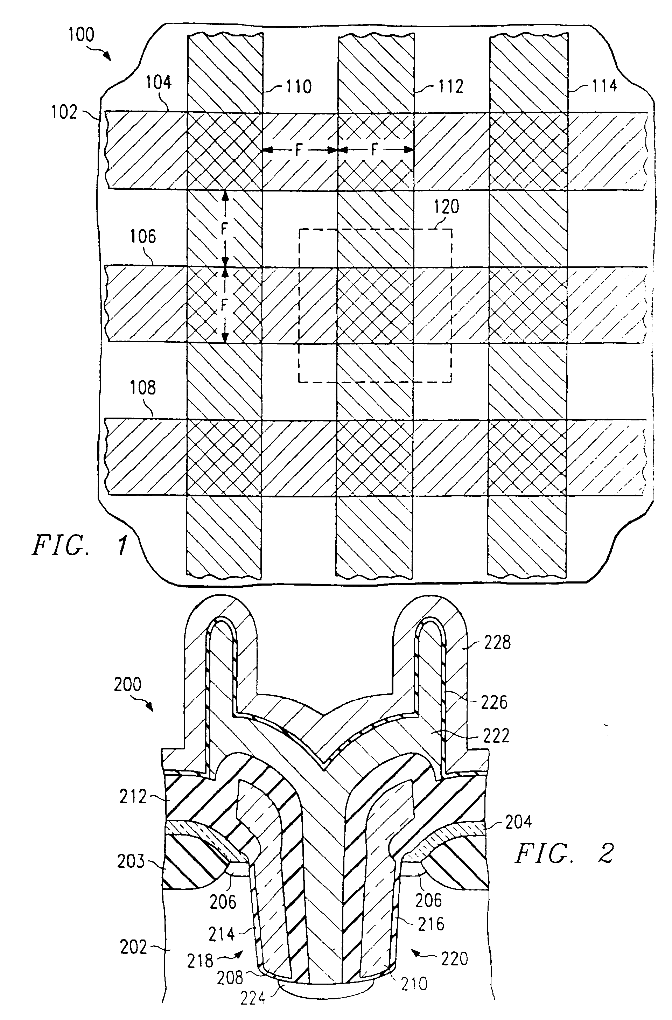

In Figure 1, a DRAM device comprises an array 100 of memory cells formed in and on a substrate 102. The substrate 102 carries on its top surface word lines 104, 106 and 108 and bit lines 110, 112 and 114. Although only three word lines and three bit lines are depicted, a normal DRAM device will have plural word and bit lines across each array of memory cells. In a cross point array, the memory cells occur at the intersections of each word line and each bit line.

The word lines 104, 106 and 108 extend substantially parallel to one another and the bit lines 110, 112 and 114 extend substantially parallel to one another. The word lines extend substantially perpendicular to the bit lines. The word lines each have a width of substantially a certain dimension F and are separated from one another by the same certain dimension F. The bit lines also each have a width of substantially a certain dimension F and are separated from one another by the same certain dimension F. The certain dimension F also represents the minimum feature size for the processing or manufacture of the memory device.

Dashed line outline box 120 indicates the plane area of the substrate 102 that is allotted for each memory cell in cross point array 100. In this arrangement, a perimeter of each memory cell abuts the perimeter of adjacent memory cells to cover the top surface of the substrate in the memory cell array. The area of each memory cell thus becomes represented by the expression 4F² where F is the certain dimension earlier noted. If in practice a DRAM device can be made to embody memory cells of this minimum area, then the memory cells have attained theoretical limits.

In Figure 2, one stacked capacitor memory cell 200 could be used in a cross point cell array. Cell 200 is formed in and on a substrate 202 of semiconductor material such as silicon. LOCOS insulating material 203 defines the active area of the cell and electrically insulates the cell 200 from other cells. A bit line 204 extends over the LOCOS material 203 to electrically contact one of a source/drain electrode 206 of a MOS transistor. Electrode 206 is square or circular and thus appears two places in the figure.

Two parts 208 and 210 of a word line also extend across the top of substrate 202 and down into the substrate. These two parts 208 and 210 are part of a single word line and present a square or circular arrangement down into substrate 202 resulting in a vertical sectional view with two parts. The two parts 208 and 210 are enclosed in insulating material 212 that serves as a dielectric material between the word line parts 208 and 210 and the substrate 202 at areas 214,216. Thus arranged, the word line parts 208 and 210 form a gate or gates of a MOS transistor. The volume of the substrate material at 218 and 220 opposite the dielectric material 214 and 216 from the parts 208 and 210 thus form channel regions of the MOS transistor. Again, the channel regions are square or circular to present two parts in vertical cross section.

A storage electrode 222 extends down into the space between the wordline parts 208 and 210 and electrically contacts a part 224 of the substrate material forming the other of the source/drain electrode of the MOS transistor. The storage electrode extends up over the top of the substrate 202 and above the word line and bit line 204. The top of the storage electrode is covered with a dielectric material 226 and a plate electrode 228 to form a storage capacitor. This capacitor has the shape of a crown and is stacked above the gate of the underlying pass transistor. The storage capacitor stores charge passing across the bit line and through the transistor under control of the word line.

The one source/drain electrode 206 is formed by diffusion from the bit line 204 material and the other source/drain electrode 224 is formed by diffusion from the storage electrode 222 material.

Cell 200 is formed by roughly the following process. Form the active region and isolation using a first mask. Deposit a conductive material, pattern it with a second mask and etch the conductive material to form the bit lines. Deposit an interlayer insulating material. Using a third mask, form an opening into the substrate through the interlayer insulating material and the bit line. Grow the gate dielectric material from SiO2. Deposit a gate material for the transistor, intentionally using a process that results in poor step coverage. Etch back the gate material for the transistor. Stop the etch when a hole is formed through the gate material at the bottom of the trench. Deposit a conductive material, pattern it with a fourth mask and etch the conductive material to form the word lines.

Deposit an interlayer insulating material, intentionally using a process that results in poor step coverage. Etch back the interlayer insulating material, stopping the etch when a hole is formed through the insulating material at the bottom of the trench. Deposit a conductive layer, pattern it with a fifth mask and etch the material to result in the storage electrode or node. Form the capacitor dielectric over the storage node and deposit plate material.

Any desired configuration of the storage capacitor can be used with this invention. For example, the capacitor could take the shape of a crown or it could have fins.

The problems with this memory cell are two-fold: electrical noise in the bit line coupled from the substrate and the number of masks required to form the cell. The electrical noise occurs generally in the substrate and is coupled into the bit line through the p-n junction between the source/drain electrode 206 and substrate 202. While five masks may equal some recent attempts to reduce the number of masks for manufacturing, two lithographic processes were needed to locate the active region and form the trench at the crossing of the bit and word lines.

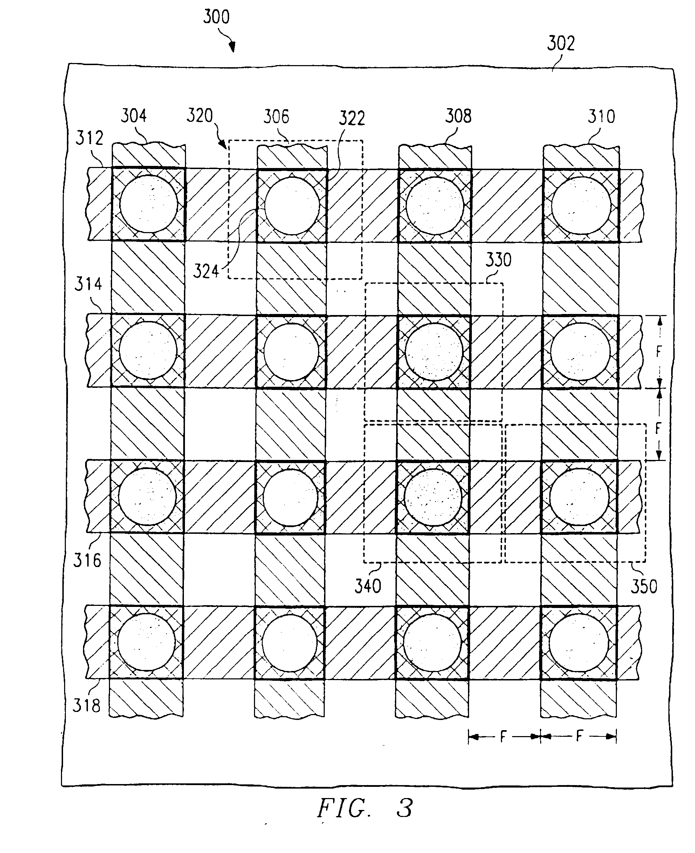

In Figure 3, memory array 300 of the present invention comprises substrate 302 carrying bit lines 304, 306, 308 and 310 and word lines 312, 314, 316 and 318. Like in Figure 1, the word lines are parallel with one another; the bit lines are parallel with one another, and the word lines are perpendicular to the bit lines. Again, the word and bit lines have widths of substantially a certain dimension F and are separated by the same certain dimension F. The dimension F represents the minimum feature size.

Memory cells, such as cell 320, depicted in dashed line outline, occur at the intersection of each word and bit line. Each memory cell, such as cell 320, comprises a storage node 322, which in this embodiment is square in plan view and has an area calculated by the square of the feature size or F². Under storage node 322 lies a vertically arranged pass transistor for each cell. The vertically arranged pass transistor connects to a bit line at its top and to a storage node at its bottom.

In each cell, such as 320, an upstanding portion 324 occurs. In Figure 3, this upstanding portion 324 is shown as circular. A chamber extends down into the upstanding portion and provides for a portion of the storage node or electrode to extend up from the bottom of the transistor to an overlying capacitor dielectric and plate.

Dashed line outlines 320, 330, 340 and 350 each represent the areas over the substrate 302 available and used for each memory cell. The areas of the upstanding portions 324 contain the pass transistor while the areas 320, 330, 340 and 350 are substantially available for the cell capacitors. The area needed for the transistor thus is smaller than the area needed for the capacitor and the transistor is located centrally and completely under the capacitor.

As explained in connection with Figure 2, each capacitor comprises a storage node, a thin layer of dielectric material and a plate node or electrode. As explained in connection with Figure 1, each cell occupies substantially an area described as four times the square of the feature size F, or 4F². The margins of the storage nodes of each memory cell cannot extend completely to the margins of the areas 320, 330, 340 and 350 because they would touch one another electrically.

The storage nodes 322 have dimensions of substantially the feature size and are separated from one another a distance of substantially the feature size along the bit line and word line. The dielectric and plate material effectively electrically isolate the capacitors of each memory cell from one another. The thickness of the dielectric and plate materials typically are much smaller than the feature size F. Each capacitor thus occupies an area over the substrate of substantially F².

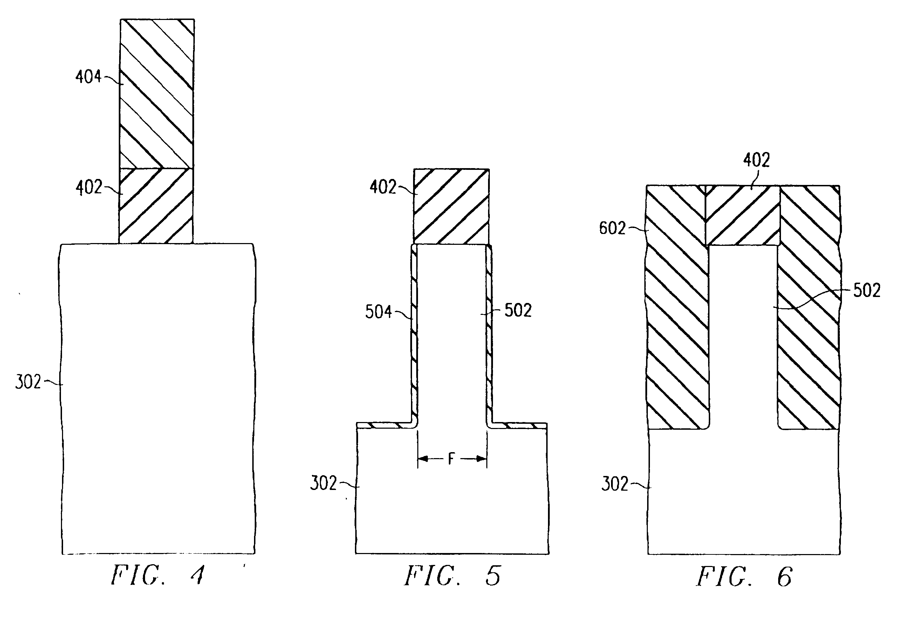

Following Figures 4 through 18 are used to describe the process steps used to make one of the memory cells, such as cell 320.

In Figure 4, a layer of Si3N4 has been deposited on substrate 302 and has been coated with resist material 404. The resist material 404 has been patterned with a first mask and the Si3N4 material has been etched to leave the rectangular plug 402 of Si3N4 material.

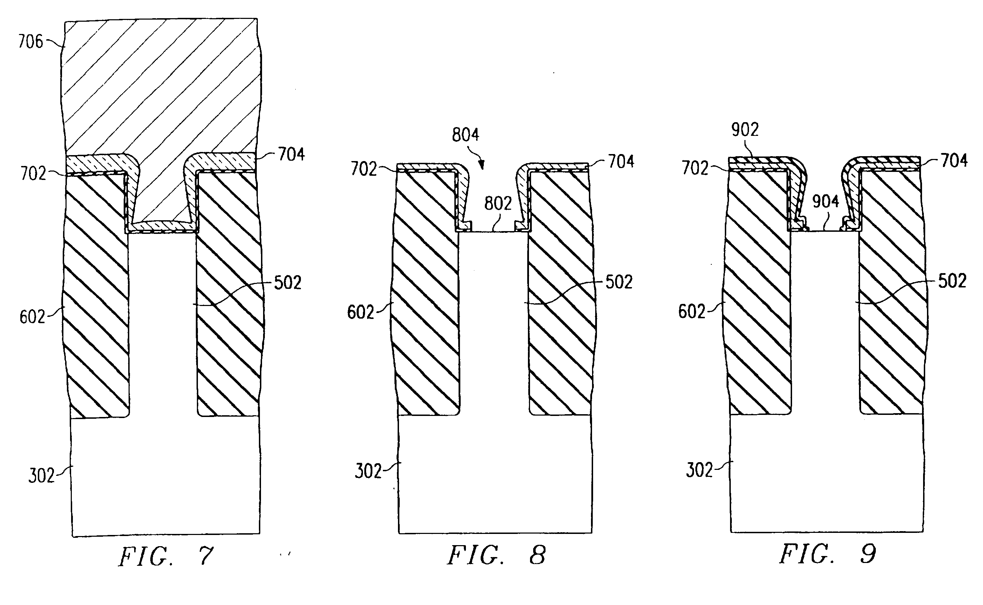

In Figure 5, the resist material has been removed and the semiconductor material of the substrate 302 is etched to leave an upstanding portion 502, with a circular or square cross-section, of semiconductor material under the plug 402. The upstanding portion 502 could also be described as a pillar and the spaces between the upstanding portions could be described as trenches or trench isolation spaces. This occurs for each memory cell to be formed so that there is a plurality of such upstanding portions 502 over the substrate area on which the cross point array or arrays are to be formed. An insulating layer 504 of SiO2 then is grown on the exposed top surface of the substrate and sides of portion 502.

In Figure 6, the voids or trench isolation spaces between the upstanding portions are filled by depositing an insulating layer 602 of SiO2 over the substrate. The layer 602 could also be described as a trench isolation material. The top surface is planarized by such as CMP. This leaves the upstanding portions 502 electrically isolated from one another except through the underlying substrate semiconductor material. So far, the process is a part of a general formation process of trench isolation regions between pillars.

In Figure 7, the plug of Si3N4 has been removed and a layer 702 of doped polysilicon has been deposited on the remaining structures. A layer 704 of low resistance material is then deposited over the structures intentionally using a process with poor step coverage. The structure then is coated with resist 706, patterned with a mask and the layers 704 and 702 are etched to form the bit lines.

In Figure 8, the resist is removed and the layers 702 and 704 are etched back until an opening 802 is formed through the doped polysilicon at the bottom of trench 804.

In Figure 9, a layer 902 of Si3N4 or SiO2 is deposited over the layer 704 with a process intentionally providing a poor step coverage. Layer 902 then is etched back until an opening 904 is formed through layer 902 at the bottom of the trench.

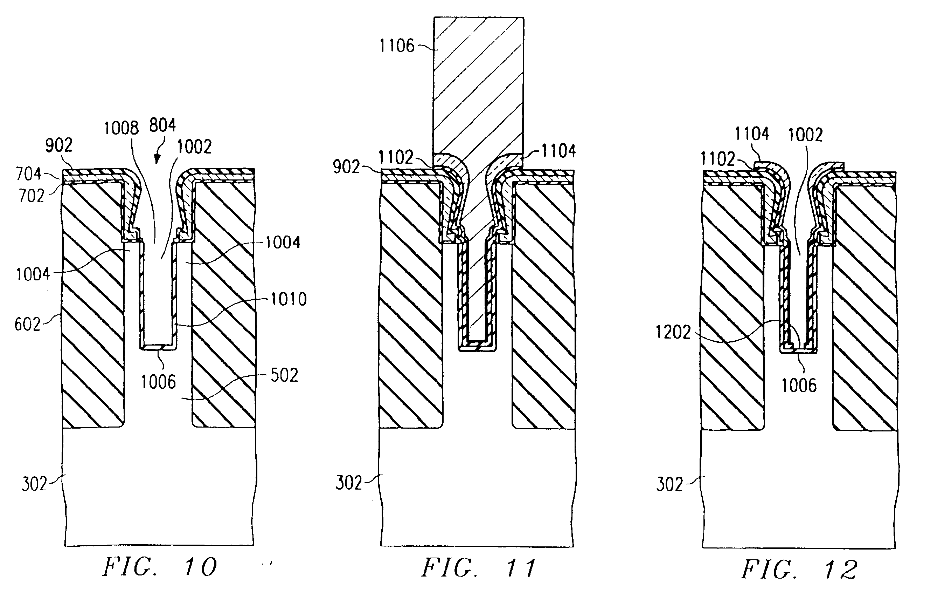

In Figure 10, the semiconductor material in upstanding portion 502 is etched through the opening in the bottom of trench 804 to form a chamber 1002. Chamber 1002 has side walls 1004, a bottom wall 1006 and an opening 1008 to the top of the chamber. Chamber 1002 can also be described as a trench. A layer 1010 of insulating material such as SiO2 is then grown on the interior surface of chamber 1002.

In Figure 11, a layer of doped polysilicon 1102 is deposited over layer 902. A layer 1104 of low resistance material then is deposited over layer 1102, intentionally using a process with a poor step coverage. A layer 1106 of resist material then is deposited over the layers, patterned with a mask and the layers 1102 and 1104 are etched to form the word lines.

In Figure 12, the resist is removed and the layers 1102 and 1104 are etched back. The etching is stopped when a hole 1202 is formed through the low resistance material layer 1104 and doped polysilicon layer 1102 at the bottom wall 1006 of chamber 1002.

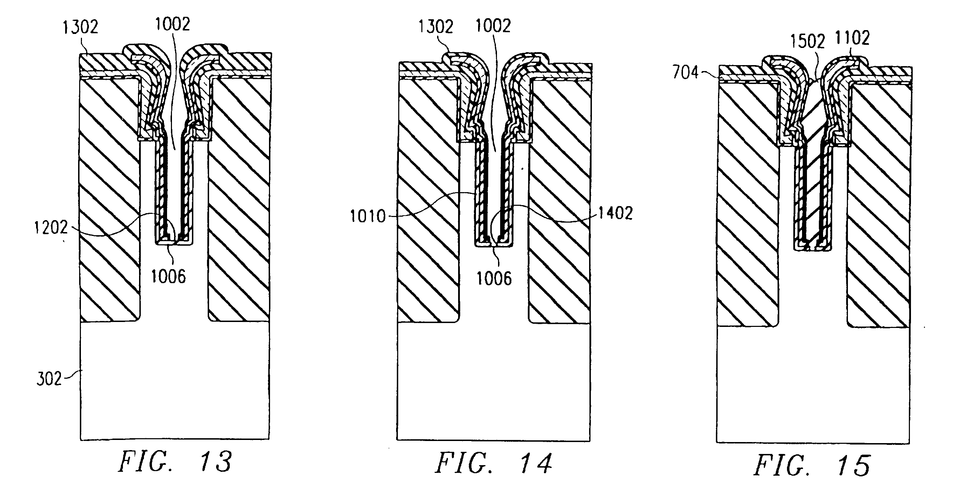

In Figure 13, a layer 1302 of insulating material such as Si3N4 or Si02 is deposited over the other layers intentionally using a process with poor step coverage. This layer 1302 covers the layers chamber, but avoids filling the hole 1202 at the bottom wall 1006 of chamber 1002.

In Figure 14, another etch back occurs to reduce the thickness of the insulating layer 1302. The etch is stopped when a hole 1402 is formed through the SiO2 layer 1010 at the bottom wall 1006 of the chamber 1002. This etch can be adjusted to equalize the etching rates for the Si3N4 and the SiO2 materials if Si3N4 is used for the interlayer insulator 1302.

The rest of the processing to complete the capacitor and other circuits on the DRAM device or chip can be performed as desired.

In Figure 15, the chamber is filled with a doped polysilicon material 1502 and etched back to a level near the top surface of the bit line 704 and word line 1102.

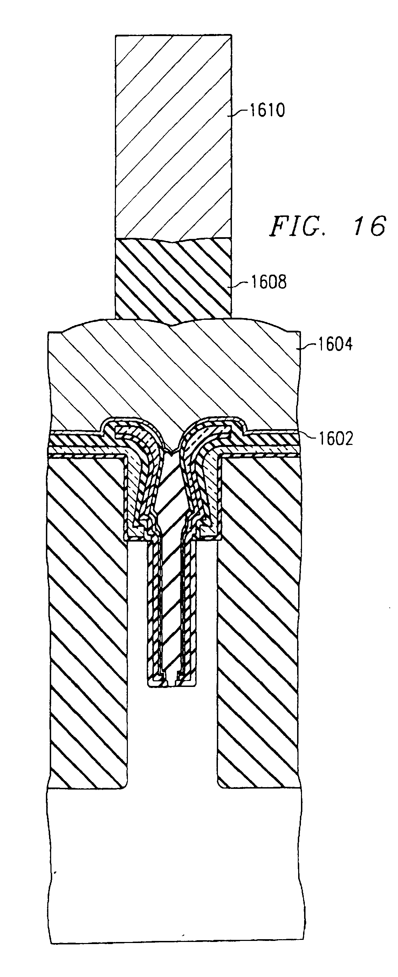

In Figure 16, a layer 1602 of barrier metal, such as TiN, is deposited over the underlying layers. A storage node layer 1604 of such as platinum Pt, is deposited over the layer 1602. A layer 1608 of SiO2 then is deposited to act as a hard mask material for etching the storage node material 1604. A layer of resist 1610 then is applied, patterned with a mask and used to etch the layer 1608 of SiO2 material.

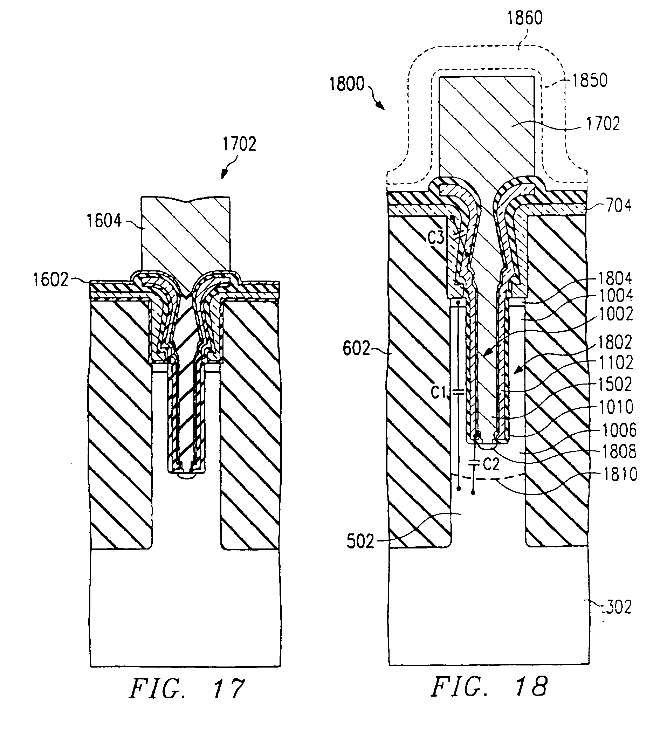

In Figure 17, the layer 1610 of resist is removed and the patterned layer 1608 of SiO2 material then is used as mask to etch the storage node or electrode material 1604 to a desired configuration. The layer 1608 of SiO2 material then is removed, leaving the plug 1702 of storage node material 1604 extending above the remaining layers.

In Figure 18, the cross point DRAM memory cell 1800 resulting from the described process steps obtains a MOS pass transistor 1802 formed in and around chamber 1002, now filled with storage node material 1502. The dopant from the bit line diffuses into the tops 1804 of the chamber side walls to form one of the source/drain electrodes of the MOS transistor. The part or parts of the word line 1102 that extend down into the chamber form the gate of the MOS transistor. The layer 1010 of insulating material forms the gate dielectric of the MOS transistor and the semiconductor material of the walls 1004 of the chamber form the channel of the MOS transistor. The dopant from the storage node material 1502 diffuses into the semiconductor material in the bottom wall of the chamber to form the other of the source/drain electrodes 1808.

Additional steps form a capacitor dielectric layer 1850 from a desired material and deposit a plate material 1860 over the dielectric material 1850. The dielectric layer 1850 covers the storage node 1702 and the plate electrode 1860 covers the dielectric layer 1850. One capacitor, comprised of the one storage node 1702, dielectric layer 1850 and plate 1860, extends to occupy substantially an area of F² over the substrate.

The capacitor may be arranged differently from that depicted to provide other geometric shapes and areas as desired. For example, the storage node may extend vertically and may provide so-called crown or finned shapes or formations. The storage node may also extend laterally over the areas between the word and bit lines to occupy an area wider than F². These and other variations are within present skills and the scope of the following claims.

In this structure, the overall capacitance formed between the bit line 704 and the substrate 302 becomes very small compared to earlier cells. The parasitic capacitance occurs from two major factors: one is the capacitance C1 of the depletion region at the p-n junction between the bit line and substrate; the second is the series capacitance C2 between the transistor gate and the substrate and the capacitance C3 between the transistor gate and the bit line.

The first component of C1 capacitance is negligible since the width of the depletion region between the bit line and substrate is large compared to the prior cells. This results from the fully depleted region, extending down to about line 1810, between the transistor gate and the trench isolation region 602; that is to say, the depleted region is formed of the channel region or side walls 1004 of the upstanding portion of semiconductor material 502 extending down to about dashed line 1810.

Due to these effects, the parasitic capacitance between the bit line and substrate is very small and bit line potential is not affected by substrate noise. Thus this structure provides for an effective open bit line architecture.

Also, the process steps described uses only four masks: active region, bit line, word line and storage node definition. This achieves a 20 percent cost reduction in cell or MOS transistor and capacitor formation.

The application may be practiced other than as specifically described. For example, other materials can be used as desired in place of the materials described. The dimensions of the electrodes, nodes and other elements of the MOS transistor and capacitor can be selected as desired while remaining within the scope of the claims. The length of the MOS transistor channel now can be selected as desired by selecting the height of the chamber or trench in the upstanding portion or pillar. The width of the channel can be selected by selecting the diameter, which determines the inner circumference, of the chamber. The channel depth can be selected by selecting the thickness of the chamber walls.

## Claims

1. A process for fabricating a dynamic random access memory cell comprising:
forming substantially upstanding portions of semiconductor material on a substrate, said portions being electrically isolated from one another;
connecting a bit line to an upper region of one upstanding portion to form a current guiding terminal of a MOS transistor in the portion;
forming an opening extending into the one upstanding portion;
forming a word line into the opening along side walls of said upstanding portion to provide a control terminal of the MOS transistor such that a channel region of the MOS transistor is formed in side walls adjacent the gate;
filling the remaining portions of the opening with a storage electrode electrically connected to a lower region of the upstanding portion including forming the other of the source/drain terminal of the MOS transistor in the lower region.

2. A process of fabricating a DRAM device having a plurality of memory cells comprising:
patterning a substrate of semiconductor material with a first mask to form active areas of semiconductor material for the cells:
patterning bit lines, carried on the substrate, with a second mask;
patterning word lines, carried on the substrate, with a third mask; and
patterning storage nodes, carried on the substrate, with a fourth mask.

3. A dynamic random access memory device comprising:
a substrate of semiconductor material having a surface;
an array of word lines carried on the surface of the substrate, the word lines extending substantially parallel with one another, each word line having a width of substantially a predetermined dimension and the word lines being separated from one another by substantially the predetermined dimension;
an array of bit lines carried on the surface of the substrate, the bit lines extending substantially parallel with one another and substantially perpendicular to the word lines, each bit line having a width of substantially the predetermined dimension and the bit lines being separated from one another by substantially the predetermined dimension;
a plurality of memory cells each located at the intersection of a word line and a bit line, each memory cell including:
a portion of upstanding semiconductor material electrically separated from adjacent memory cells, the upstanding portion containing a chamber having side walls, a bottom wall and an opening to the top of the chamber between the tops of the side walls;
a part of a bit line extending to and making electrical connection with the top of the side walls to form a current guiding terminal of a MOS transistor;
a part of a word line extending into the chamber and being electrically separated from the side walls to form a control region of the MOS transistor with a part of the side walls adjacent to the control region forming a channel region of the MOS transistor; and
a part of the semiconductor material under the bottom wall forming the other of the current guiding terminals of the MOS transistor; and
a storage electrode extending down into the chamber and making electrical connection with the part of the semiconductor material under the bottom wall, the storage electrode extending above the bit line and the word line.

4. The device of Claim 3, wherein the side walls are circular to form one transistor around the chamber.

5. The device of claim 3 in which the transistor is vertical.

6. The device of any of Claims 3 to 5 wherein the upstanding portion has a diameter substantially the predetermined dimension.

7. The device of any of Claims 3 to 6 wherein the upstanding portion extends up from the substrate a distance great enough so that the other of the current guiding terminals remains within the portion.

8. The device of any of Claims 3 to 7 wherein the upstanding portion is electrically isolated from the other portions by trench isolation.

9. The device of any of Claims 3 to 8 wherein the top of the side walls are below the bit line and word line.

10. The device of any of Claims 3 to 9 wherein the thickness of the side walls determines the depth of the channel region.

11. A DRAM device comprising:
a substrate;
a plurality of upstanding portions formed on the substrate and isolated from one another laterally by a trench isolation arrangement;
a pass transistor formed in each upstanding portion; and
a capacitor formed at each upstanding portion.

12. A DRAM device comprising:
substrate of semiconductor material;
an array of word lines formed on the substrate, the word lines extending substantially parallel with one another, each word line having a width of substantially a predetermined dimension and the word lines being separated from one another by substantially the predetermined dimension;
an array of bit lines formed on the substrate, the bit lines extending substantially parallel with one another and substantially perpendicular to the word lines, each bit line having a width of substantially the predtermined dimension and the bit lines being separated from one another by substantially the predetermined dimension;
a plurality of memory cells each located at the intersection of a word line and a bit line, each memory cell including a pass transistor and a capacitor, each memory cell occupying an area over the substrate of substantially four times the square of the predetermined dimension.

13. The device of Claim 12, wherein the pass transistor occupies an area over the substrate of substantially the predetermined dimension multiplied by the predetermined dimension.

14. A dynamic random access memory cell comprising:
a portion of semiconductor material upstanding from a substrate and electrically isolated from other portions of semiconductor material upstanding from the substrate, the upstanding portion containing a chamber having side walls, a bottom wall and an opening to the top of the chamber between the tops of the side walls;
the top of the side walls forming a current guiding terminal of a MOS transistor;
a gate electrode extending into the chamber and being electrically separated from the side walls to form a control region of the MOS transistor with a part of the side walls adjacent to the control region forming a channel region of the MOS transistor;
a part of the semiconductor material under the bottom wall forming the other of the current guiding terminals of the MOS transistor; and
a storage electrode extending down into the chamber and making electrical connection with the part of the semiconductor material under the bottom wall, the storage electrode extending above the opening.
